# EUROPÄISCHE PATENTSCHRIFT

(11) **EP 1 466 367 B1**
(45) Veröffentlichungstag und Bekanntmachung des Hinweises auf die Patenterteilung: **04.02.2009**
(21) Anmeldenummer: 02791620.4
(22) Anmeldetag: 10.12.2002
(51) Int. Cl.: H01L 27/115, H01L 21/8246

(54) **NICHTFLÜCHTIGE ZWEITRANSISTOR-HALBLEITERSPEICHERZELLE SOWIE ZUGEHÖRIGES HERSTELLUNGSVERFAHREN**
NON-VOLATILE TWO-TRANSISTOR SEMICONDUCTOR MEMORY CELL AND METHOD FOR PRODUCING THE SAME
CELLULE DE MEMOIRE NON VOLATILE A SEMI-CONDUCTEURS A DEUX TRANSISTORS, ET PROCEDE DE PRODUCTION Y RELATIF

(30) Priorität: 15.01.2002 DE 10201303
(43) Veröffentlichungstag der Anmeldung: 13.10.2004
(60) Teilanmeldung: 08167292.5
(73) Patentinhaber: Infineon Technologies AG, 81669 München (DE)
(72) Erfinder: SCHULER, Franz, B-3000 Leuven (BE); TEMPEL, Georg, D-01277 Dresden (DE)
(74) Vertreter: Karl, Frank
(86) Internationale Anmeldenummer: PCT/DE2002/004521
(87) Internationale Veröffentlichungsnummer: WO 2003/061011

(56) Entgegenhaltungen:
- EP-A- 1 102 319
- US-B1- 6 316 317
- PATENT ABSTRACTS OF JAPAN Bd. 0154, Nr. 23 (E-1127), 28. Oktober 1991 (1991-10-28) & JP 3 177065 A (KAWASAKI STEEL CORP), 1. August 1991 (1991-08-01)

## Beschreibung

Die vorliegende Erfindung bezieht sich auf eine nichtflüchtige Zweitransistor-Halbleiterspeicherzelle sowie ein zugehöriges Verfahren zu deren Verstellung und insbesondere auf eine nichtflüchtige Halbleiterspeicherzelle mit einem Speichertransistor und einem damit verbundenen Auswahltransistor.

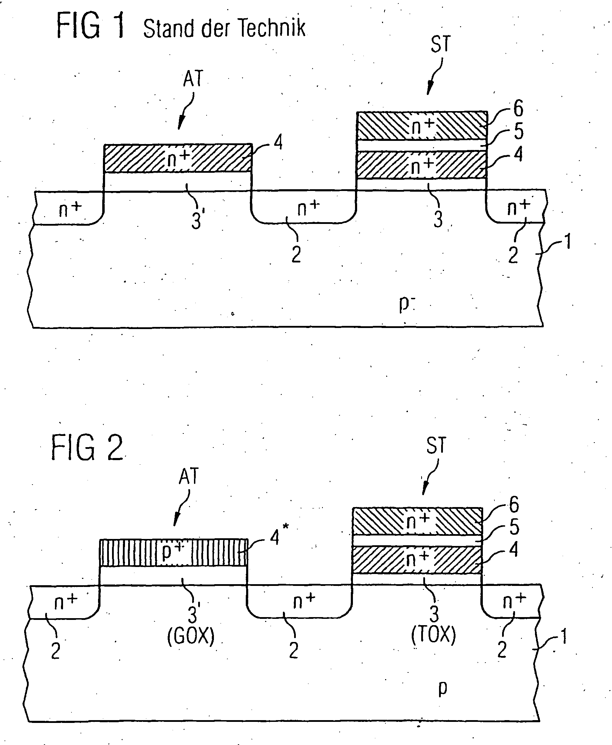

Figur 1 zeigt eine vereinfachte Schnittansicht einer derartigen herkömmlichen nichtflüchtigen Zweitransistor-Halbleiterspeicherzelle, wobei in einem Halbleitersubstrat 1, welches beispielsweise p⁻-dotiert ist, ein Auswahltransistor AT sowie ein Speicher transistor ST ausgebildet und über ein gemeinsaines Source-/Draingebiet 2 miteinander verbunden sind.

Der Speichertransistor ST besteht üblicherweise aus einer isolierenden Tunneloxidschicht 3, einer leitenden Floating-Gate-Schicht 4, einer isolierenden dielektrischen Schicht 5 und einer leitenden Steuer-Gate-Schicht 6. Zur Speicherung von Informationen werden Ladungen vom Halbleitersubstrat 1 in die Floating-Gate-Schicht 4 eingebracht. Verfahren zum Einbringen der Ladungen in die Floating-Gate-Schicht 4 sind beispielsweise Injektion heißer Ladungsträger und Fowler-Nordheim-Tunneln.

Zum Auswählen bzw. Ansteuern des eigentlichen Speichertransistors ST besitzt die Zweitransistor-Halbleiterspeicherzelle ferner einen Auswahltransistor AT, der als Feldeffekttransistor im Wesentlichen eine Gateoxidschicht 3' und eine darüber liegende Steuer-Gate-Schicht 4 aufweist. Die Floating-Gate-Schicht des Speichertransistors und die Steuer-Gate-Schicht des Auswahltransistors bestehen üblicherweise aus dem gleichen Material wie z.B. Polysilizium, welches beispielsweise n⁺-dotiert ist.

Bei derartigen nichtflüchtigen Zweitransistor-Halbleiterspeicherzellen sind insbesondere die Ladungshalteeigenschaften für den Einsatz und die Zuverlässigkeit von großer Bedeutung. Diese Ladungshalteeigenschaften sind üblicherweise durch (anomalen) Ladungsverlust begrenzt, der sich auf Grund von Leckphänomenen ergibt. Dieser Ladungsverlust geschieht beispielsweise auf Grund von Traps bzw. Störstellen innerhalb des Tunneloxids 3, wobei ein Tunnelmechanismus durch diese Störstellen bzw. Traps unterstützt wird (trap assisted tunneling). Zur Vermeidung von derartigen Leckströmen bzw. zur Verbesserung der Ladungshalteeigenschaften werden üblicherweise die Schichtdicken für die Tunneloxidschicht 3 und/oder die dielektrische Schicht 5 erhöht, wodurch sich jedoch die elektrische Eigenschaften der Speicherzelle verschlechtern und insbesondere die Betriebsspannungen zum Lesen, Schreiben und/oder Löschen der Speicherzelle angehoben werden müssen.

Aus der Druckschrift EP 1 102 319 A1, auf.der der Oberbegriff des Patentanspruchs 1 basiert, ist eine nichtflüchtige Zweitransistor-Halbleiterspeicherzelle mit einem Speichertransistor mit einer vorbestimmten Schwellwertspannung und einem Auswahltransistor mit einer vorbestimmten Schwellwertspannung bekannt. Die Auswahltransistor-Steuerschicht und die Ladungsspeicherschicht werden hierbei in unterschiedlichen Schritten ausgebildet. Zur Vermeidung von unerwünschten Leckströmen befindet sich hierbei eine Tunnelschicht des Speichertransistors in einer zusätzlichen n-Wanne bzw. einem Kontinuitätsgebiet.

Demgegenüber liegt der Erfindung die Aufgabe zu Grunde eine nichtflüchtige Zweitransistor-Halbleiterspeicherzelle sowie ein zugehöriges Herstellungsverfahren zu schaffen, wobei verbesserte elektrische Eigenschaften einfach und kostengünstig realisierbar sind.

Erfindungsgemäß wird diese Aufgabe hinsichtlich der Speicherzelle durch die Merkmale des Patentanspruchs 1 und hinsichtlich des Verfahrens durch die Maßnahmen des Patentanspruchs 6 gelöst.

Insbesondere durch die unterschiedliche Dotierung der Ladungsspeicherschicht im Speichertransistor und der Auswahltransistor-Steuerschicht im Auswahltransistor zur unabhängigen Optimierung der zugehörigen Schwellwertspannungen, kann ohne Verschlechterung der elektrischen Eigenschaften der Speicherzelle eine Verbesserung der Ladungshalteeigenschaften im Speichertransistor realisiert werden.

Vorzugsweise weisen die Auswahltransistor-Steuerschicht (4*) und die Ladungsspeicherschicht (4) ein unterschiedliches Material oder insbesondere bei gleichem Halbleitermaterial eine unterschiedliche Dotierung auf. Aus diese Weise kann im Speichertransistor gezielt eine Feldverringerung und damit eine Verbesserung der Ladungshaltung bewirkt werden, während der Auswahltransistor eine im Wesentlichen unveränderte Einsatzspannung bzw. Schwellwertspannung aufweist.

Vorzugsweise wird ein Halbleitersubstrat mit erhöhter Dotierung verwendet, wobei die Auswahltransistor-Steuerschicht und die Ladungsspeicherschicht ein Halbleitermaterial mit unterschiedlicher Dotierung aufweisen. Dadurch können die elektrischen Felder im Speichertransistor und damit ein auf (z.B. durch Störstellen (traps) verursachtes) Tunneln basierender Leckstrom verringert werden, da dieser Tunnelstrom exponentiell abhängig vom elektrischen Feld ist. Andererseits wird die sich daraus ergebende Einsatzspannungsverschiebung durch eine Anpassung der der Austrittsarbeiten in der Auswahltransistor-Steuerschicht durch eine entgegengesetzte Dotierung kompensiert, wodurch die absolute Schwellwertspannung des Auswahltransistors AT reduziert wird und damit der Lesestrom durch die gesamte Zelle erhöht wird. Dies wiederum erlaubt einfachere Auswerteschaltungen auf dem Chip.

Alternativ zur Erhöhung der Dotierstoffkonzentration im Substrat kann auch lediglich oder zusätzlich das Kanalgebiet bzw. eine Oberfläche des Substrats stärker dotiert werden. Ferner kann alternativ zur gesamten Dotierung des Substrats oder zur Oberflächendotierung auch eine erhöhte Wannendotierung zur Modifikation der Schwellwertspannung verwendet werden.

Hinsichtlich des Verfahrens werden vorzugsweise sowohl für den Auswahltransistor als auch den Speichertransistor eine erste Isolationsschicht, eine elektrisch leitende Halbleiterschicht, eine zweite Isolationsschicht und eine weitere elektrisch leitende Schicht ausgebildet und derart strukturiert, dass sich die beiden Transistoren mit dazwischen liegenden Source- und Draingebieten im Halbleitersubstrat ergeben. Lediglich für die elektrisch leitende Halbleiterschicht des Auswahltransistors ist hierbei eine entgegengesetzte Dotierung alternativ oder zusätzlich anzuwenden, um die Schwellwertspannung zu verringern. Auf diese Weise kann eine nichtflüchtige Zweitransistör-Halbleilterspeicherzelle mit verbesserten Ladungshalteeigenschaften besonders kostengünstig hergestellt werden.

In den weiteren Unteransprüchen sind weitere vorteilhafte Ausgestaltungen der Erfindung gekennzeichnet.

Die Erfindung wird nachstehend anhand eines Ausführungsbeispiels unter Bezugnahme auf die Zeichnung näher beschrieben.

Es zeigen:
Figur 1 eine vereinfachte Schnittansicht einer herkömmlichen nichtflüchtigen Zweitransivstor-Halbleiterspeicherzelle;
Figur 2 eine vereinfachte Schnittansicht einer erfindungsgemäßen nichtflüchtigen Zweitransistor-Halbleiterspeicherzelle;
Figuren 3A bis 3D vereinfachte Schnittansichten zur Veranschaulichung wesentlicher Herstellungsschritte der erfindungsgemäßen nichtflüchtigen Zweitransistor-Halbleiterspeicherzelle;
Figur 4a und 4B vereinfachte graphische Darstellungen zur Veranschaulichung einer Abhängigkeit der Schwellwertspannungen von der Zeit aufgrund von Ladungsverlusten; und
Figuren 5A bis 5C vereinfachte graphische Darstellungen zur Veranschaulichung der Auswirkungen einer Änderung der Austrittsarbeit auf die Schwellwertspannungen im Auswahltransistor und Speichertransistor.

Figur 2 zeigt eine vereinfachte Schnittansicht einer nichtflüchtigen Zweitransistor-Halbleiterspeicherzelle gemäß der vorliegenden Erfindung, wobei gleiche Bezugszeichen gleiche oder ähnliche Schichten bezeichnen wie in Figur 1.

Gemäß Figur 2 wird in einem Substrat 1, welches beispielsweise aus einem p-dotierten Silizium-Halbleitermaterial besteht, ein Auswahltransistor AT und ein Speichertransistor ST ausgebildet, welche über ein gemeinsames Source-/Draingebiet 2 miteinander verbunden sind. Der Speichertransistor ST besitzt eine erste Speichertransistor-Isolationsschicht 3, die vorzugsweise eine Tunneloxidschicht TOX aufweist und ca. 10 nm dick ist. An der Oberfläche dieser ersten Speichertransistor-Isolationsschicht 3, die beispielsweise aus einer thermisch ausgebildeten SiO₂-Schicht besteht befindet sich eine Ladungsspeicherschicht 4, die beispielsweise eine n⁺-dotierte Polysiliziumschicht aufweist. Darüber liegend ist eine zweite Speichertransistor-Isolationsschicht 5 angeordnet, die die Ladungsspeicherschicht 4 von einer darüber angeordneten Speichertransistor-Steuerschicht 6 isoliert. Die Speichertransistor-Steuerschicht 6 kann ebenfalls beispielsweise n⁺-dotiertes Polysilizium aufweisen und stellt im Wesentlichen eine Wortleitung der Speicherzelle dar. Die zweite Speichertransistor-Isolationsschicht 5 wird auch als Interpoly-Dielektrikum bezeichnet und kann beispielsweise eine ONO-Schichtenfolge (Oxid-Nitrid-Oxid) aufweisen.

Der Auswahltransistor AT besteht seinerseits aus einer an der Oberfläche des Substrats bzw. zwischen den Source- und Draingebieten 2 liegenden Kanalgebiets ersten Auswahltransistor-Isolationsschicht 3' und einer Auswahltransistor-Steuerschicht 4*. Die Auswahltransistor-Isolationsschicht 3' besteht vorzugsweise aus einer Gateoxidschicht GOX. Die Auswahltransistor-Steuerschicht 4* besteht ebenfalls aus einer elektrisch leitenden Schicht und beispielsweise aus einer p⁺-dotierten Polysiliziumschicht.

Der wesentliche Unterschied der erfindungsgemäßen Speicherzelle ergibt sich nunmehr aus der modifizierten Dotierung des Substrates und der sich daraus ergebenden modifizierten natürlichen Einsatzspannungen in Kombination mit der Wahl unterschiedlicher Materialien bzw. unterschiedlicher Dotierungen fuer die Ladungsspeicherschicht 4 und die Auswahltransistor-Steuerschicht 4*. Auf Grund einer erhöhten Dotierung des Substrats 1 von p⁻ beispielsweise auf p oder p⁺ bei gleichbleibenden Dotierungen für die Ladungsspeicherschicht 4 und die Speichertransistor-Steuerschicht 6 erhält man eine erhöhte Schwellwertspannung des Speichertransistors ST. Wie später im Einzelnen beschrieben wird, ergibt sich durch diese Anpassung der Schwellenwertspannung im Speichertransistor ST die Möglichkeit, die Ladungshalteeigenschaften zu optimieren. Andererseits erhält man im Auswahltransistor AT eine Verringerung der Schwellwertspannung durch eine zur Ladungsspeicherschicht 4 entgegengesetzte Dotierung. Genauer gesagt wird durch die p⁺-Dotierung der Auswahltransistor-Steuerschicht 4* die Erhöhung dessen Schwellwertspannung kompensiert, wodurch sich im Wesentlichen eine erniedrigte Schwellwertspannung im Auswahltransistor ergibt und somit eine nicht dargestellte Auswerteschaltung zum Auswerten der Speicherzelle einfacher verwirklicht werden kann.

Wesentlich für das vorliegende Konzept ist demnach, dass im Speichertransistor ST die Schwellwertspannung ueber die Substrat-, Wannen- und/oder Kanaldotierung bzgl. Ladungshaltung optimiert werden kann und dass die sich dadurch fuer den Auswahltransistor ergebenden Nachteile durch eine der Ladungsspeicherschicht entgegengesetzten Dotierung kompensiert werden können. Dadurch können die für das Tunneln verantwortlichen elektrischen Felder im Speichertransistor verringert werden, wodurch sich eine verbesserte Ladungshalteeigenschaft ergibt, wobei hinsichtlich einer Außenbeschaltung die elektrischen Eigenschaften der Zelle unverändert bleiben, da im Auswahltransistor AT diese Schwellwertverschiebung wieder kompensiert wird.

Obwohl vorstehend ein gleiches Material (Polysilizium) mit unterschiedlicher Beschaffenheit (Dotierung) verwendet wurde, erhält man den gleichen Effekt auch bei Einsatz von unterschiedlichen Materialien (unterschiedliche Halbleiter usw.) für die Ladungsspeicherschicht 4 und die Auswahltransistor-Steuerschicht 4*.

Eine genaue Erläuterung der vorstehend beschriebenen Zusammenhänge erfolgt nachstehend, wobei jedoch zunächst ein mögliches Verfahren zur Herstellung einer derartigen nichtflüchtigen Zweitransistor-Halbleiterspeicherzelle beschrieben wird.

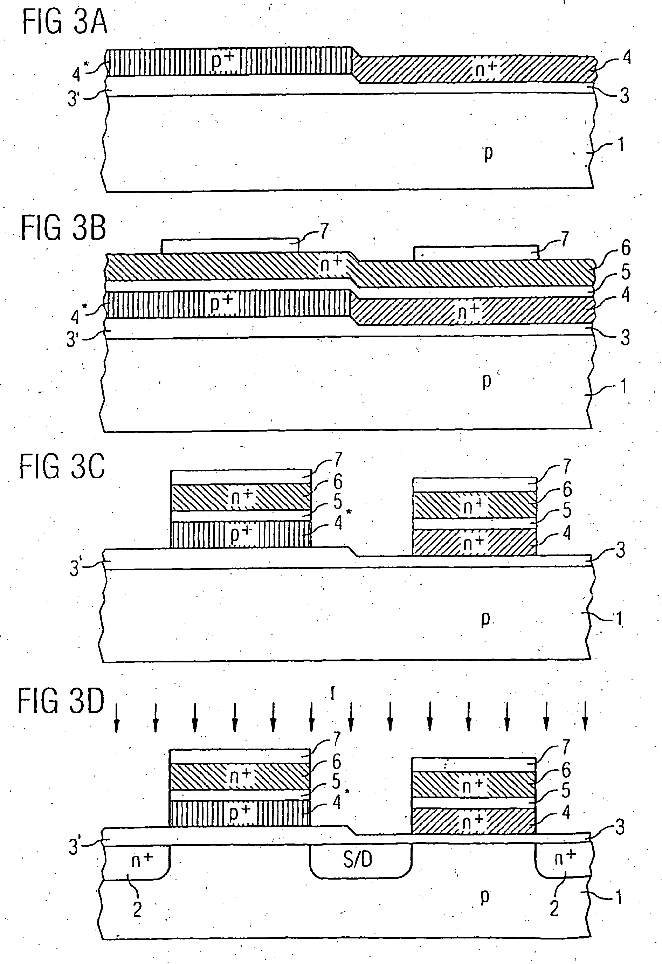

Figuren 3A bis 3D zeigen vereinfachte Schnittansichten zur Veranschaulichung wesentlicher Herstellungsschritte der erfindungsgemäßen nichtflüchtigen Zweitransistor-Halbleiterspeicherzelle, wobei gleiche Bezugszeichen gleiche oder ähnliche Schichten bezeichnen und auf eine wiederholte Beschreibung nachfolgend verzichtet wird.

Gemäß Figur 3A wird zunächst auf einem Substrats 1, welches beispielsweise ein Silizium-Halbleitersubstrat mit einer erhöhten p-Dotierung aufweist eine erste Isolationsschicht 3 sowohl in einem Auswahltransistor-Bereich als auch in einem Speichertransistor-Bereich ausgebildet. Diese erste Isolationsschicht 3 bzw. 3' besteht beispielsweise aus einem thermisch ausgebildeten Siliziumdioxid. Ein positiver Effekt einer ausreichend dicken ersten Isolationsschicht bzw. Gateoxidschicht 3' im Auswahltransistor-Bereich ist die Vermeidung einer Dotierstoff- beispielsweise Bor-Penetration in das Substrat 1, die sich aus einer nachfolgenden Dotierung ergeben kann.

Nachfolgend wird an der Oberfläche eine elektrisch leitende Halbleiterschicht 4 bzw. 4* (z.B. Polysiliziumschicht) ausgebildet, wobei diese Schicht beispielsweise durch eine Maske im Bereich des Speichertransistors ST eine zur Dotierung des Substrats 1 entgegengesetzte Dotierung wie z.B. eine n⁺-Dotierung aufweist. Demgegenüber kann beispielsweise durch eine Maskierung die elektrisch leitende Halbleiterschicht 4* mit einer zum Substrat 1 gleichen Dotierung vom ersten Leitungstyp dotiert werden wie z.B. einer p⁺-Dotierung. Auf diese Weise werden bereits die vorstehend beschriebenen Einsatzspannungen bzw. Schwellwertspannungen in den verschiedenen Bereichen unterschiedlich eingestellt, wobei vorzugsweise eine Schwellwertspannung im Auswahltransistor-Bereich derart das sich kein Unterschied zum Auswahltransistor einer herkömmlichen nichtflüchtigen Zweitransistor-Halbleiterspeicherzelle ergibt, wodurch z.B. bereits existierende Auswerteschaltungen bzw. -konzepte problemlos übernommen werden können.

Alternativ kann jedoch auch eine überlagerte Dotierung stattfinden, wobei beispielsweise zunächst eine n-dotierte-elektrisch leitende Schicht sowohl für den Auswahltransistor-Bereich als auch für den Speichertransistor-Bereich (beispielsweise insitu dotiert) abgeschieden wird und anschließend für den Auswahltransistor-Bereich eine Gegendotierung beispielsweise mit einer maskierten Implantation erfolgt. Grundsätzlich kann die erste ganzflächige Dotierung auch durch eine ganzflächige Implantierung oder eine sonstige Dotierung durchgeführt werden.

Die Herstellung der verschieden dotierten Polyschichten 4 und 4⁺ erfolgt vorzugsweise mittels herkömmlicher Fototechnik und Implantation, wobei eine davon ganzflächig erfolgen kann und nur die zweite beispielsweise mittels Fototechnik maskiert wird. Somit erfolgt bei dieser Dotierung eine Überkompensation der ersten Dotierung. Für die p-Dotierung der elektrisch leitenden Halbleiterschicht 4* im Auswahltransistor-Bereich wird üblicherweise Bor verwendet, während für die n-Dotierung im Speichertransistor-Bereich üblicherweise eine Phosphor- oder Arsen-Dotierung durchgeführt wird.

Gemäß Figur 3B wird in einem nachfolgenden Schritt eine zweite Isolationsschicht 5 an der Oberfläche der elektrisch leitenden Halbleiterschicht 4 bzw. 4* ausgebildet, wobei diese zumindest im Speichertransistor-Bereich ausgebildet werden muss. Diese zweite Isolationsschicht 5 wird üblicherweise als Inter-Poly-Dielektrikum bezeichnet und kann beispielsweise eine ONO-Schichtenfolge aufweisen, wodurch sich besonders gute Isolationseigenschaften bei guter kapazativer Ankopplung realisieren lassen und insbesondere Leckströme zu einer nachfolgend ausgebildeten weiteren elektrisch leitenden Schicht 6 verhindert werden. Die weitere elektrisch leitende Schicht 6 besteht beispielsweise wiederum aus einer n⁺-dotierten Polysiliziumschicht, die mit einem herkömmlichen Verfahren abgeschieden oder aufgewachst wird.

Abschließend wird eine Maskenschicht 7 an der Oberfläche von zumindest der weiteren elektrisch leitenden Schicht 6 im Speichertransistor-Bereich ST und der elektrisch leitenden Halbleiterschicht im Auswahltransistor-Bereich AT ausgebildet und strukturiert, wobei beispielsweise eine herkömmliche Hartmaskenschicht verwendet werden kann.

Gemäß Figur 3C wird nunmehr unter Verwendung der strukturierten Maskenschicht 7 zunächst die weitere elektrisch leitende Schicht 6 teilweise entfernt, wodurch man zunächst die Wortleitungen der Speichertransistoren ST und darüber hinaus durch weiteres Entfernen der Schichten bis zur elektrisch leitenden Halbleiterschicht 4 bzw. 4* auch die Leitungen der Auswahlgates der Auswahltransistoren erhält. Zum Entfernen dieser Schichten 4 bzw. 4*, 5 und 6 kann ein jeweils verfügbares Standardätzverfahren verwendet werden, wobei insbesondere anisotrope Atzverfahren in Betracht kommen, die selektiv zur ersten Isolationsschicht 3, 3' und zur Maskenschicht 7 wirken.

Gemäß Figur 3D wird in einem abschließenden Herstellungsschritt eine selbstjustierende Implantation I zur Realisierung der Source-/Draingebiete 2 durchgeführt, wobei zur Herstellung eines NMOS-Transistors eine n⁺-Dotierung beispielsweise mittels Phosphor oder Arsen erfolgt. Weitere Herstellungsschritte zu Fertigstellung der Zweitransistor-Halbleiterspeicherzelle werden nachfolgend nicht beschrieben, da sie allgemein bekannt sind.

Die für den Auswahltransistor AT nicht benötigten Schichten 5, 6 und 7 bleiben hierbei unbeschaltet oder können in einem nachfolgenden Verfahrensschritt entfernt werden. Auf diese Weise erhält man eine nichtflüchtige Zweitransistor-Halbleiterspeicherzelle mit verbesserten Ladungshalteeigenschaften, die auf besonders einfache Art und Weise hergestellt werden kann.

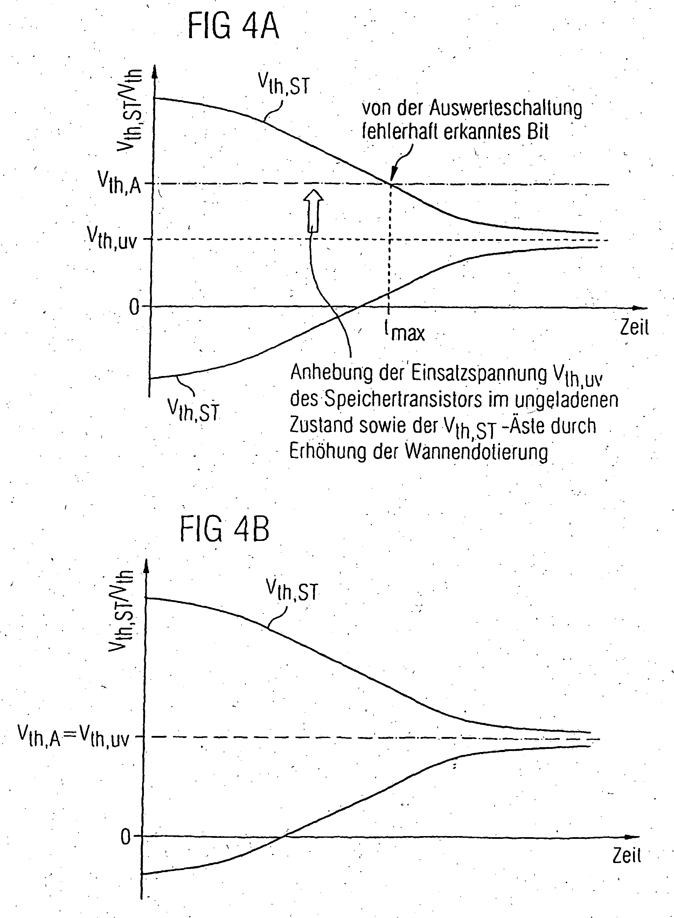

Zur Veranschaulichung der Wirkungsweise der erfindungsgemäßen Speicherzelle werden anhand von Figuren 4A und 4B die Einflüsse einer Schwellwertspannung im Speichertransistor auf die Ladungshalteeigenschaften beschrieben.

Figur 4A zeigt eine graphische Darstellung der in einer Speicherzelle maßgeblichen Schwellwertspannungen und ihre zeitliche abhängigkeit, wenn die Speicherzelle (anomale) Ladungsverlusteffekte zeigt.

Gemäß Figur 4A ist mit V_{th,uv} eine Einsatzspannung bzw. Schwellwertspannung des Speichertransistors ST in einem ungeladenen Zustand (z.B. nach einem UV-Löschen) dargestellt. Die Äste V_{th,ST} zeigen die Schwellwertspannung des Speichertransistors ST im geladenen Zustand bzw. den transienten Verlauf der Einsatzspannung bis hin zum sogenannten ungeladenen Zustand, bei dem sich in der ladungsspeichernden Schicht 4 keinerlei Ladungen befinden. Diese Entladung ergibt sich im Wesentlichen durch z.B. störstellenunterstütztes Tunneln (trap assisted tunneling) hervorgerufene Leckströme.

Mit V_{th,A} ist eine Schwellwertspannung einer üblicherweise notwendigen Auswerteschaltung für die Speicherzelle dargestellt, die mehr oder weniger hoch bzw. fein sein kann. Grundsätzlich gilt jedoch, dass eine zugehörige Auswerteschaltung besonders einfach und kostengünstig hergestellt werden kann, je höher diese Spannung,V_{th,A} ist. Andererseits zeigt die Figur 4A, dass je höher diese Schwellwertspannung V_{th,A} ist, um so früher ein Zeitpunkt tₘₐₓ erreicht wird, zu dem ein abgespeichertes Bit nur noch fehlerhaft von der Auswerteschaltung erkannt wird.

Mit der vorliegenden Erfindung erfolgt nunmehr eine Anhebung der Einsatzspannung V_{th,UV} des Speichertransistors ST im ungeladenen Zustand sowie seiner zugehörigen Entladekurven V_{th,ST} durch beispielsweise die vorstehend beschriebene Erhöhung einer Substratdotierung, einer Kanalgebietdotierung, und/oder einer Wannendotierung. Als Ergebnis dieser Anhebung der Einsatzspannung V_{th,UV} erhält man die in Figur 4B dargestellte Idealkurve, wobei man eine verbesserte Ladungshalteeigenschaft erhält, da die Schwellwertspannung V_{th,A} der Auswerteschaltung mit der Schwellwertspannung V_{th,UV} des Speichertransistors zusammenfällt.

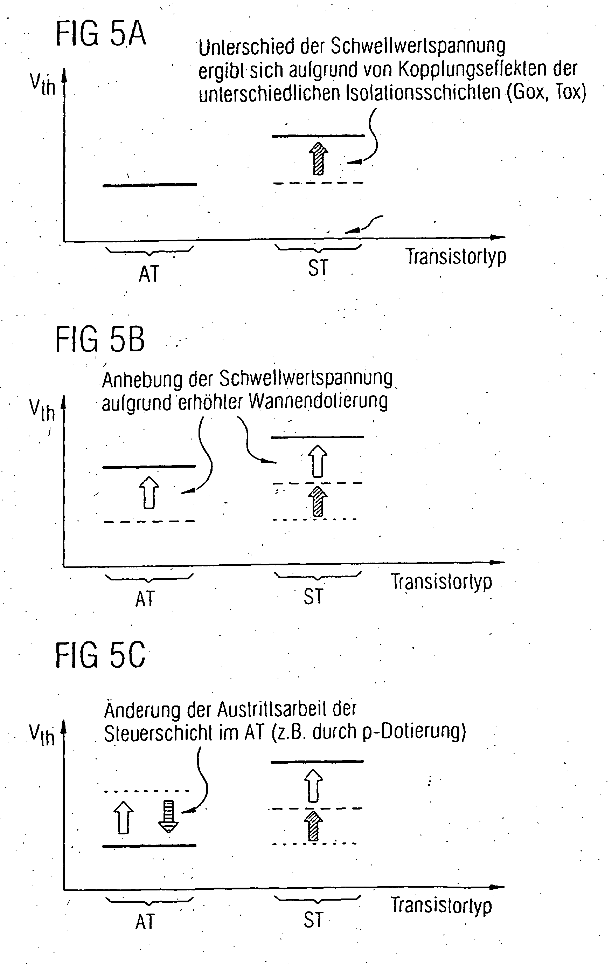

Figuren 5A bis 5C zeigen graphische Darstellungen zur weiteren. Veranschaulichung der erfindungsgemäßen Schwellwertänderungen auf Grund der Änderungen der Substratdotierung bzw. der entgegengesetzen Gate-Dotierung des Auswahltransistors (unterschiedliche Beschaffenheit von Ladungsspeicherschicht und Auswahltransistor-Steuerschicht).

Figur 5A zeigt eine graphische Darstellung der Schwellwertspannungen Vₜₕ für einen Auswahltransistor AT und einen Speichertransistor ST, wobei sich auf Grund von Kopplungseffekten der unterschiedlichen Isolationsschichten GOX und TOX sowie der Schicht 5 in den jeweiligen Bereichen bereits ein Unterschied der jeweiligen Schwellwertspannungen ergibt. Im Regelfall besitzt der im gleichen Substrat 1 ausgebildete Speichertransistor ST einen höheren Schwellwert Vₜₕ als der zugehörige Auswahltransistor AT.

Gemäß Figur 5B wird nunmehr die Wirkung der Erhöhung der Substratdotierung beschrieben, wobei durch die erhöhte Dotierung im Substrat 1, durch eine erhöhte Wannendotierung und/oder eine erhöhte Oberflächendotierung beide Schwellwertspannungen gleichermaßen angehoben werden. Auf diese Weise erhalt man zwar bereits die in Figur 4B verbesserten Ladungshalteeigenschaften im Speichertransistor ST, jedoch sind die elektrischen Eigenschaften der Speicherzelle insbesondere auf Grund der erhöhten Schwellwertspannungen im Auswahltransistor wesentlich verschlechtert.

Gemäß Figur 5C erfolgt demzufolge eine Korrektur der Schwellwertanhebung im Auswahltransistor AT, die im Wesentlichen durch eine Erhöhung der Austrittsarbeit für Elektronen in der Steuerschicht beispielsweise durch eine entgegengesetzte p-Dotierung erfolgt. Durch diese Änderung der Austrittsarbeit lediglich im Auswahltransistor AT wird demzufolge die Schwellwertspannung Vₜₕ in diesem Bereich wieder zurückgedrückt, wodurch man eine dem Ausgangszustand ähnliche Schwellwertspannung und somit ähnlich gute elektrische Eigenschaften der Speicherzelle erhält. Auf diese Weise können die Ladungshalteeigenschaften in einer Zweitransistor-Halbleiterspeicherzelle ohne Beeinflussung der elektrischen Eigenschaften oder einer notwendigen Auswerteschaltung wesentlich verbessert werden.

Die Erfindung wurde vorstehend anhand einer NMOS-Speicherzelle beschrieben. Sie ist jedoch nicht darauf beschränkt und umfasst in gleicher Weise PMOS- oder eine Kombination von PMOS- und NMOS-Zellen bzw. Transistoren. In gleicher Weise ist die Erfindung nicht auf Silizium-Halbleitermaterialien beschränkt, sondern umfasst alle weiteren Halbleitermaterialien, mit denen gezielt eine Schwellwertspannung zur Verbesserung der Ladungshalteeigenschaften verändert werden kann. In gleicher Weise kann für die Speichertransistor-Steuerschicht nicht nur ein Halbleitermaterial verwendet werden, sondern in gleicher Weise ein alternatives Material wie z.B. Metalle.

## Patentansprüche

1. Nichtflüchtige Zweitransistor-Halbleiterspeicherzelle mit
einem Speichertransistor (ST) mit einer vorbestimmten Schwellwertspannung, der in einem Substrat (1) ein Source- und Draingebiet (2) mit einem dazwischen liegenden Kanalgebiet aufweist, wobei an der Oberfläche des Kanalgebiets eine erste Speichertransistor-Isolationsschicht (3), eine Ladungsspeicherschicht (4), eine zweite Speichertransistor-Isolationsschicht (5) und eine Speichertransistor-Steuerschicht (6) ausgebildet ist; und
einem Auswahltransistor (AT) mit einer vorbestimmten Schwellwertspannung, der im Substrat (1) ein Source- und Draingebiet (2) mit einem dazwischen liegenden Kanalgebiet aufweist, wobei an der Oberfläche des Kanalgebiets eine erste Auswahltransistor-Isolationsschicht (3') und eine Auswahltransistor-Steuerschicht (4*) ausgebildet ist,
**dadurch gekennzeichnet, dass**
die Schwellwertspannungen im Auswahl- und Speichertransistor (AT, ST) aufgrund unterschiedlicher Isolationsschichten (3, 3') unterschiedlich sind und durch eine erhöhte Substrats/Wannendotierung von einem ersten Leitungstyp (p) angehoben werden, wobei
zur Korrektur der Schwellwertanhebung im Auswahltransistor (AT) die Auswahltransistor-Steuerschicht (4*) ein Halbleitermaterial mit einer Dotierung vom ersten Leitungstyp (p), und die Ladungsspeicherschicht (4) ein Halbleitermaterial mit einer zum ersten Leitungstyp entgegengesetzten Dotierung vom zweiten Leitungstyp (n) aufweist.

2. Nichtflüchtige Zweitransistor-Halbleiterspeicherzelle nach Patentanspruch 1,
**dadurch gekennzeichnet, dass** die Erhöhung der Dotierstoffkonzentration vom ersten Leitungstyp (p) in den Kanalgebieten erfolgt.

3. Nichtflüchtige Zweitransistor-Halbleiterspeicherzelle nach einem der Patentansprüche 1 oder 2,
**dadurch gekennzeichnet, dass** die erste Speichertransistor-Isolationsschicht (3) und die erste Auswahltransistor-Isolationsschicht (3') eine SiO₂-Schicht aufweisen.

4. Nichtflüchtige Zweitransistor-Halbleiterspeicherzelle nach einem der Patentansprüche 1 bis 3,
**dadurch gekennzeichnet, dass** die Ladungsspeicherschicht (4) und die Auswahltransistor-Steuerschicht (4*) eine Polysilizium-Schicht aufweisen.

5. Nichtflüchtige Zweitransistor-Halbleiterspeicherzelle nach einem der Patentansprüche 1 bis 4,
**dadurch gekennzeichnet, dass** der Speichertransistor (ST) und der Auswahltransistor (AT) einen NMOS- und/oder einen PMOS-Transistor darstellen.

6. Verfahren zur Herstellung einer nichtflüchtigen Zweitransistor-Halbleiterspeicherzelle mit den Schritten:
a) Ausbilden von unterschiedlichen Isolationsschichten (3, 3') für einen Auswahltransistor (AT) mit einer vorbestimmten Schwellwertspannung und einen Speichertransistor (ST) mit einer vorbestimmten Schwellwertspannung auf einem Halbleitersubstrat (1), das eine Dotierung vom ersten Leitungstyp (p) aufweist;
b) Ausbilden einer Halbleiterschicht (4) an der Oberfläche der ersten Isolationsschicht (3, 3');
c) Ausbilden einer zweiten Isolationsschicht (5) an der Oberfläche der elektrisch leitenden Halbleiterschicht (4) zumindest im Bereich des Speichertransistors (ST);
d) Ausbilden einer weiteren elektrisch leitenden Schicht (6) an der Oberfläche der zweiten Isolationsschicht (5) zumindest im Bereich des Speichertransistors (ST);
e) Ausbilden und Strukturieren einer Maskenschicht (7);
f) Ausbilden von Schichtstapeln im Bereich des Auswahltransistors (AT) und des Speichertransistors (ST) unter Verwendung der strukturierten Maskenschicht (7); und
g) Ausbilden von Source- und Draingebieten (2) mit einer Dotierung vom zweiten Leitungstyp (n) unter Verwendung der Schichtstapel als Maske, wobei
in Schritt a) beide Schwellwertspannungen im Auswahl- und Speichertransistor (AT, ST) unterschiedlich sind und durch eine erhöhte Dotierung des Halbleitersubstrats (1) angehoben werden, und wobei
in Schritt b) zur Korrektur der Schwellwertanhebung im Auswahltransistor (AT) die Halbleiterschicht (4) in einem Bereich des Auswahltransistors (AT) eine Dotierung vom ersten Leitungstyp (p) und in einem Bereich des Speichertransistors (ST) eine zum ersten Leitungstyp entgegengesetzte Dotierung vom zweiten Leitungstyp (n) aufweist.

7. Verfahren nach Patentanspruch 6,
**dadurch gekennzeichnet, dass** in Schritt a) ein Halbleitersubstrat (1) mit erhöhter Grunddotierung, Wannendotierung und/oder Oberflächendotierung vom ersten Leitungstyp (p) verwendet wird.

8. Verfahren nach einem der Patentansprüche 6 oder 7,
**dadurch gekennzeichnet, dass** in Schritt a) im Bereich des Speichertransistors (ST) eine Tunneloxidschicht (TOX) und im Bereich des Auswahltransistors (AT) eine. Gateoxidschicht. (GOX) ausgebildet wird.

9. Verfahren nach einem der Patentansprüche 6 bis 8,
**dadurch gekennzeichnet, dass** in Schritt b) eine Polysilizium-Schicht abgeschieden wird und die unterschiedliche Dotierung im Bereich des Auswahltransistors (AT) und des Speichertransistors (ST) durch eine maskierte Implantation erfolgt.

10. Verfahren nach einem der Patentansprüche 6 bis 9,
**dadurch gekennzeichnet, dass** in Schritt c) eine ONO-Schichtenfolge ausgebildet wird.

11. Verfahren nach einem der Patentansprüche 6 bis 10,
**dadurch gekennzeichnet, dass** in Schritt d) eine weitere Polysilizium-Schicht abgeschieden wird, die eine Dotierung vom zweiten Leitungstyp (n) aufweist.

12. Verfahren nach einem der Patentansprüche 6 bis 11,
**dadurch gekennzeichnet, dass** in Schritt e) eine Hartmaskenschicht ausgebildet wird.

13. Verfahren nach einem der Patentansprüche 6 bis 12,
**dadurch gekennzeichnet, dass** in Schritt f) ein anisotropes Ätzverfahren durchgeführt wird.

14. Verfahren nach einem der Patentansprüche 6 bis 13,
**dadurch gekennzeichnet, dass** in Schritt g) eine Ionenimplantation (I) durchgeführt wird.

## Claims

1. Nonvolatile two-transistor semiconductor memory cell having
a memory transistor (ST) having a predetermined threshold voltage, which has a source and drain region (2) with a channel region lying in between in a substrate (1), a first memory transistor insulation layer (3), a charge storage layer (4), a second memory transistor insulation layer (5) and a memory transistor control layer (6) being formed at the surface of the channel region; and
a selection transistor (AT) having a predetermined threshold voltage, which has a source and drain region (2) with a channel region lying in between in the substrate (1), a first selection transistor insulation layer (3') and a selection transistor control layer (4*) being formed at the surface of the channel region,
**characterized in that**
the threshold voltages in the selection and memory transistors (AT, ST) are different on account of different insulation layers (3, 3') and are raised by an increased substrate/well doping of a first conduction type (p), in which case for correction of the threshold raising in the selection transistor (AT), the selection transistor control layer (4*) has a semiconductor material with a doping of the first conduction type (p), and the charge storage layer (4) has a semiconductor material with a doping of the second conduction type (n), which doping is opposite to the first conduction type.

2. Nonvolatile two-transistor semiconductor memory cell according to Patent Claim 1,
**characterized in that** the dopant concentration of the first conduction type (p) is increased in the channel regions.

3. Nonvolatile two-transistor semiconductor memory cell according to either of Patent Claims 1 and 2, **characterized in that** the first memory transistor insulation layer (3) and the first selection transistor insulation (3') have an SiO₂ layer.

4. Nonvolatile two-transistor semiconductor memory cell according to one of Patent Claims 1 to 3, **characterized in that** the charge storage layer (4) and the selection transistor control layer (4*) have a polysilicon layer.

5. Nonvolatile two-transistor semiconductor memory cell according to one of Patent Claims 1 to 4, **characterized in that** the memory transistor (ST) and the selection transistor (AT) represent an NMOS and/or a PMOS transistor.

6. Method for fabricating a nonvolatile two-transistor semiconductor memory cell having the following steps:
a) formation of different insulation layers (3, 3') for a selection transistor (AT) having a predetermined threshold voltage and a memory transistor (ST) having a predetermined threshold voltage on a semiconductor substrate (1), which has a doping of the first conduction type (p);
b) formation of a semiconductor layer (4) at the surface of the first insulation layer (3, 3');
c) formation of a second insulation layer (5) at the surface of the electrically conductive semiconductor layer (4) at least in the region of the memory transistor (ST);
d) formation of a further electrically conductive layer (6) at the surface of the second insulation layer (5) at least in the region of the memory transistor (ST);
e) formation and patterning of a mask layer (7);
f) formation of layer stacks in the region of the selection transistor (AT) and of the memory transistor (ST) using the patterned mask layer (7); and
g) formation of source and drain regions (2) with a doping of the second conduction type (n) using the layer stack as mask, in which case
in step a), the two threshold voltages in the selection and memory transistors (AT, ST) are different and are raised by an increased doping of the semiconductor substrate (1), and in which case
in step b), for correction of the threshold raising in the selection transistor (AT), the semiconductor layer (4) has a doping of the first conduction type (p) in a region of the selection transistor (AT) and a doping of the second conduction type (n), which doping is opposite to the first conduction type, in a region of the memory transistor (ST).

7. Method according to Patent Claim 6,
**characterized in that**, in step a), a semiconductor substrate (1) with increased basic doping, well doping and/or surface doping of the first conduction type (p) is used.

8. Method according to either of Patent Claims 6 or 7,
**characterized in that**, in step a), a tunnel oxide layer (TOX) is formed in the region of the memory transistor (ST) and a gate oxide layer (GOX) is formed in the region of the selection transistor (AT).

9. Method according to one of Patent Claims 6 to 8, **characterized in that**, in step b), a polysilicon layer is deposited and the different doping in the region of the selection transistor (AT) and of the memory transistor (ST) is effected by a masked implantation.

10. Method according to one of Patent Claims 6 to 9, **characterized in that**, in step c), an ONO layer sequence is formed.

11. Method according to one of Patent Claims 6 to 10, **characterized in that**, in step d), a further polysilicon layer is deposited, which has a doping of the second conduction type (n).

12. Method according to one of Patent Claims 6 to 11, **characterized in that**, in step e), a hard mask layer is formed.

13. Method according to one of Patent Claims 6 to 12, **characterized in that**, in step f), an anisotropic etching method is carried out.

14. Method according to one of Patent Claims 6 to 13, **characterized in that**, in step g), an ion implantation (I) is carried out.

## Revendications

1. Cellule de mémoire non volatile à semi-conducteurs à deux transistors, comprenant
un transistor (ST) de mémoire, ayant une tension de valeur de seuil déterminée à l'avance, qui a dans un substrat (1) une zone (2) de source et de drain avec une zone de canal entre elles, dans lequel à la surface de la zone de canal est formée une première couche (3) isolante de transistor de mémoire, une couche (4) de mémoire de charge, une deuxième couche (5) isolante de transistor de mémoire et une couche (6) de commande de transistor de mémoire ; et
un transistor (AT) de sélection ayant une tension de valeur de seuil déterminée à l'avance, qui a dans le substrat (1) une zone (2) de source et de drain avec une zone de canal entre elles, dans lequel il est formé à la surface de la zone de canal une première couche (3') isolante de transistor de sélection et une couche (4*) de commande de transistor de sélection,
**caractérisée en ce que**,
les tensions de valeur de seuil du transistor (AT, ST) de sélection et de mémoire sont différentes en raison de couches (3, 3') isolantes différentes et peuvent être élevées par un dopage plus grand substrat/caisson d'un premier type (p) de conductivité, dans laquelle
pour la correction de l'élévation de la valeur de seuil du transistor (AT) de sélection, la couche (4*) de commande du transistor de sélection a une matière semi-conductrice ayant un dopage du premier type (p) de conductivité et la couche (4) de mémoire de charge a une matière semi-conductrice ayant un dopage du deuxième type (n) de conductivité opposé au premier type de conductivité.

2. Cellule de mémoire non volatile à semi-conducteurs à deux transistors suivant la revendication 1, **caractérisée en ce que** l'élévation de la concentration de la substance de dopage du premier type (p) de conductivité s'effectue dans les zones de canal.

3. Cellule de mémoire non volatile à semi-conducteurs à deux transistors suivant l'une des revendications 1 ou 2, **caractérisée en ce que** la première couche (3) isolante du transistor de mémoire et la première couche (3') isolante du transistor de sélection ont une couche en SiO₂.

4. Cellule de mémoire non volatile à semi-conducteurs à deux transistors suivant l'une des revendications 1 à 3, **caractérisée en ce que** la couche (4) de mémoire de charge et la couche (4*) de commande de transistor de sélection ont une couche en polysilicium.

5. Cellule de mémoire non volatile à semi-conducteurs à deux transistors suivant l'une des revendications 1 à 4, **caractérisée en ce que** le transistor (ST) de mémoire et le transistor (AT) de sélection constituent un transistor NMOS- et/ou un transistor PMOS.

6. Procédé de fabrication d'une cellule de mémoire non volatile à semi-conducteurs à deux transistors, comprenant les stades dans lesquels :
a) on forme deux couches (3, 3') isolantes différentes pour un transistor (AT) de sélection ayant une tension de valeur de seuil déterminée à l'avance et un transistor (ST) de mémoire ayant une tension de valeur de seuil déterminée à l'avance sur un substrat (1) semi-conducteur qui a un dopage du premier type (p) de conductivité ;
b) on forme une couche (4) semi-conductrice à la surface de la première couche (3, 3') isolante ;
c) on forme une deuxième couche (5) isolante à la surface de la couche (4) semi-conductrice conductrice de l'électricité au moins dans la région du transistor (ST) de mémoire ;
d) on forme une autre couche (6) conductrice de l'électricité à la surface de la deuxième couche (5) isolante au moins dans la région du transistor (ST) de mémoire ;
e) on forme et on structure une couche (7) de masque ;
f) on forme des piles de couches dans la région du transistor (AT) de sélection et du transistor (ST) de mémoire en utilisant la couche (7) de masque structurée ; et
g) on forme des zones (2) de source et de drain ayant un dopage du deuxième type (n) de conductivité en utilisant la pile de couches comme masque, dans lequel
au stade a) les deux tensions de valeur de seuil des transistor (AT) de sélection et du transistor (ST) de mémoire sont différentes et sont relevées par un plus grand dopage du substrat (1) semi-conducteur, et dans lequel,
au stade b), pour la correction de l'élévation de la valeur de seuil du transistor (AT) de sélection, la couche (4) semi-conductrice a, dans une région du transistor (AT) de sélection un dopage du premier type (p) de conductivité, et dans une région du transistor (ST) de mémoire, un dopage du deuxième type (n) de conductivité opposé au premier type de conductivité.

7. Procédé suivant la revendication 6,
**caractérisé en ce que** au stade a) on utilise un substrat (1) semi-conducteur ayant un dopage de base surélevé, un dopage de caisson et/ou un dopage de surface du premier type (p) de conductivité.

8. Procédé suivant l'une des revendications 6 ou 7,
**caractérisé en ce qu'**au stade a) on forme dans la zone du transistor (ST) de mémoire une couche (TOX) d'oxyde de tunnel et dans la zone du transistor (AT) de sélection une couche (GOX) d'oxyde de grille.

9. Procédé suivant l'une des revendications 6 à 8, **caractérisé en ce qu'**au stade b) on dépose une couche de polysilicium et l'on effectue le dopage différent dans la région du transistor (AT) de sélection et du transistor (ST) de mémoire par une implantation masquée.

10. Procédé suivant l'une des revendications 6 à 9, **caractérisé en ce que** dans le stade c) on forme une succession de couches ONO.

11. Procédé suivant l'une des revendications 6 à 10, **caractérisé en ce que** dans le stade d) on dépose une autre couche de polysilicium, qui a un dopage du deuxième type (n) de conductivité.

12. Procédé suivant l'une des revendications 6 à 11, **caractérisé en ce que** dans le stade e) on forme une couche de masque dure.

13. Procédé suivant l'une des revendications 6 à 12, **caractérisé en ce que** dans le stade f) on effectue un procédé d'attaque anisotrope.

14. Procédé suivant l'une des revendications 6 à 13, **caractérisé en ce que** dans le stade g) on effectue une implantation (I) d'ions.
